# EUROPEAN PATENT SPECIFICATION

(11) **EP 3 326 888 B1**
(45) Date of publication and mention of the grant of the patent: **25.08.2021**
(21) Application number: 17202928.2
(22) Date of filing: 21.11.2017
(51) Int. Cl.: B61L 15/00, G01M 17/08, G01R 31/00, B61L 27/00

(54) **TEST DEVICE FOR AND METHOD OF TESTING INTEROPERABILITY OF RAILWAY VEHICLES**
PRÜFVORRICHTUNG UND VERFAHREN ZUR PRÜFUNG DER INTEROPERABILITÄT VON SCHIENENFAHRZEUGEN
DISPOSITIF DE TEST ET PROCÉDÉ PERMETTANT DE TESTER L'INTEROPÉRABILITÉ DE VÉHICULES FERROVIAIRES

(30) Priority: 23.11.2016 GB 201619799
(43) Date of publication of application: 30.05.2018
(73) Proprietor: Bombardier Transportation GmbH, 10785 Berlin (DE)
(72) Inventor: Villa, Giovanna, 17100 Savona (IT); Rössling, Stefan, 68305 Mannheim (DE); Mazzone, Andrea, 8008 Zürich (CH)
(74) Representative: Patentanwälte Bressel und Partner mbB

(56) References cited:
- WO-A1-2016/102160
- DE-A1-102012 013 059
- US-A- 5 265 832
- US-A- 5 446 389
- US-A1- 2015 276 555

## Description

The invention relates to a test device for testing interoperability of railway vehicles. Furthermore, the invention relates to a method of testing interoperability of railway vehicles. In particular, the test device and the method serve to verify and validate the interoperability.

Railway trains comprise several railway vehicles coupled together, such as locomotives, end carriages (motored or non-motored) and central carriages (motored or non-motored). Optionally, a plurality of carriages may form a consist which is coupled always as a complete unit to a railway train and the individual carriages of which are not coupled to a railway train separately. Typically, there is at least one communication channel (wired and/or wireless) extending within the railway train and communicatively connecting different railway vehicles within the train. Examples are wire train bus (WTB), train lines (TL), Ethernet train network and Universal Mobile Telecommunications System (UMTS). The term "communication channel" includes a channel realized using a data bus onboard a train. The invention is applicable to any type of communication channel and to any set or subset of communication channels as well as to any communication technology or combination of communication technologies that the railway vehicle is designed to support.

During inauguration and operation of a train, communication signals are transferred via the at least one communication channel between the different railway vehicles, which are coupled together. For example, an end carriage comprises the driver controls and a central carriage comprises traction motors and a pantograph. During inauguration, a request signal for requesting the pantograph to rise and contact an electric overhead line is transferred from the end carriage to the central carriage. When the pantograph has been raised, a confirmation signal is transferred from the central carriage to the end carriage.

There are many processes during inauguration and during operation of a train which require communication signals via the at least one communication channel. Typically, each vehicle within the train comprises several devices (such as passenger door controllers, traction and brake control, pantograph and pantograph motor control, passenger information system), which can communicate with devices in other vehicles of the train. Therefore, a train is a complex system and a failure of a single device may affect the operation of devices in other vehicles of the train. Furthermore, different combinations of vehicles can be coupled together so as to form a train. For example, the same end carriages can be coupled with a different number of central carriages and/or consists and, in case the train has a locomotive, there can be one or more than one locomotive. In case of more than one locomotive, the train can be operated in single traction or double traction mode, i.e. only one of the locomotives or two locomotives may provide traction.

In particular immediately after commissioning of a train for the first time, but also when the number and/or type of vehicles within a train is changed, failures in the complex train system may occur for the first time and the reliable function of the train should be tested. Several test concepts can be applied. In particular, it is possible to test the interoperability of the individual devices (components) of a vehicle and of different vehicles within a train on a test stand. A corresponding train test platform is disclosed by WO 2013/156062 A1. While this concept can successfully be applied during development of components and vehicles, the effort when applying the concept during commissioning and train set up is high.

According to another concept, as disclosed by DE 10 2012 013059 A1, a test device is coupled via a coupling interface to the mechanical front coupling unit of a railway vehicle. The test device comprises an interface for diagnosis and/or maintenance. By means of the test device, the presence of an electric voltage on a control line of the railway vehicle can be detected or the resistance of a line can be measured, for example in order to check if a certain electric contact of this line is established or not.

US 2015/276555 A1 discloses a train test platform for testing actual train components of a multiple car railway train. The test platform includes a supervisor unit and several car units linked by a reflective memory system. The actual components to be tested are installed in instrumentation units of the respective car units. The instrumentation units provide break-out interfaces for connecting the actual train components to a train communication system having the wiring, bus systems, or power supplies Furthermore, the instrumentation units simulate those components not being present physically in the respective cars. All testing is controlled by the supervisor unit using the reflective memory to exchange information with the platform components in the respective car units.

WO 2016/102160 A1 relates to a method for carrying out a test process relating to a rail vehicle.

US 5,265,832 A describes a system for testing a plurality of subsystems in a multi-car train over a train-wide communications network.

US 5,446,389 A relates to a portable test kit for testing electrical and mechanical operation of a locomotive.

It is an object of the present invention to reduce the effort for testing the function of railway trains.

The attached claims define the scope of protection.

According to a basic idea of the present invention, a test device is used for testing, which simulates the behaviour of a railway vehicle with respect to at least one functionality. To perform a test, the test device is coupled to a vehicle under test by connecting the test device to the vehicle under test via at least one communication interface. The test device outputs to and receives communication signals from the vehicle under test, evaluates the received communication signals and determines whether the railway vehicle under test is correctly functioning within a railway train. Communication signals are understood to transfer data, information and/or commands.

The test device therefore tests the interoperability of the vehicle under test within a partially simulated railway train. This reduces the effort for testing different configurations of trains. The test device can simulate any railway vehicle which can be coupled with the vehicle under test to form a railway train and the test device can be coupled to different real railway vehicles under test. In addition, it is also possible to couple the test device with at least one further test device. This allows for testing the communicative behaviour of different simulated railway vehicles, which are communicatively coupled together.

In addition, since the test device may replace at least one real vehicle during the test, failures within the railway train can be located more easily and faster.

The test device can be used in particular during commissioning and maintenance of a railway train or parts of a railway train.

In particular, the test device is communicatively coupled to the vehicle under test in the same manner as the vehicle under test would be coupled with a real railway vehicle. The test device simulates the communicative behaviour of the real railway vehicle. One application is to test whether control processes within a railway train are performed correctly in which at least one control signal is transferred from a first vehicle of the train to a second vehicle of the train and in which the at least one control signal is used to control a process performed by the second vehicle. Preferably, it is also tested whether a confirmation or response signal confirming the result of the controlled process within the second vehicle is correctly transferred and received by the first vehicle. A test device can be used to simulate the first vehicle or the second vehicle.

The vehicle under test can be any railway vehicle which can be coupled together with other vehicles to form a railway train. In particular, the vehicle under test can be a single locomotive, carriage or consist, can be part of a plurality of vehicles (for example, each of the vehicles being a locomotive, a carriage or a consist) coupled together or can be the whole set of a plurality of vehicles coupled together.

In particular, the following is proposed: A test device for testing interoperability of railway vehicles that are intended (in particular adapted) to be part of a railway train, wherein the test device comprises:
- at least one interface unit adapted to establish and maintain communication between the test device and at least one railway vehicle via a train communication channel,
- at least one connector for connecting the train communication channel to the at least one interface unit,
- a data processing and control unit adapted to
   ∘ control output of communication signals via the at least one interface unit to a railway vehicle under test and
   ∘ process communication signals received via the at least one interface unit from the railway vehicle under test,
   thereby simulating a communication behaviour according to at least one functionality of a first railway vehicle coupled via the train communication channel to the railway vehicle under test,
- a user interface adapted to output test results from testing the vehicle under test to a user and/or adapted to receive control input from a user in order to initiate and/or control testing the vehicle under test.

Furthermore, it is proposed a method of testing interoperability of railway vehicles that are intended (in particular adapted) to be part of a railway train, wherein a test device is communicatively coupled to a vehicle under test, and wherein:
- at least one interface unit of the test device is used to establish and maintain communication between the test device and at least one railway vehicle via a train communication channel,
- at least one connector of the test device is used for connecting the train communication channel to the at least one interface unit,
- a data processing and control unit of the test device
   ∘ controls output of communication signals via the at least one interface unit to the railway vehicle under test and
   ∘ processes communication signals received via the at least one interface unit from the railway vehicle under test,
   thereby simulating a communication behaviour according to at least one functionality of a first railway vehicle coupled via the train communication channel to the railway vehicle under test,
- a user interface outputs test results from testing the vehicle under test to a user and/or is used to receive control input from a user in order to initiate and/or control testing the vehicle under test.

Embodiments of the test device follow from embodiments of the test method and vice versa.

Examples of functionalities are the processes of switching on and off lights, controlling traction and braking of the train and controlling the opening and closing of vehicle doors. Further examples have been described above and will be described below.

One advantage of the test device and the method of using it is the fact that there is no need to use the "first" railway vehicle during testing, since the test device replaces the first railway vehicle. As mentioned before the reference test device can replace any vehicle or any combination of several vehicles hence it can perform any functionality test required by the vehicle it replaces. Furthermore, the test can be developed to a stage which makes it possible to certify the test as a standard for testing interoperability of railway vehicles. In particular, the test can fully replace testing of complete railway trains with respect to interoperability.

Preferably, the data processing and control unit also evaluates (or is also adapted to evaluate) the communication signals received via the at least one interface unit, thereby determining whether the railway vehicle under test is correctly functioning within a railway train. Optionally, the test results also include, or consist of the evaluation and/or determination result(s).

The term "connector" not only refers to electrical connectors for connecting signal lines, but also to radio signal connectors for connecting a signal line with a radio channel (e.g. a radio transceiver) or for connecting two radio channels with each other (e.g. a radio signal repeater).

The data processing and control unit may be realised by at least one computer comprising software and hardware.

The test device may be a physical unit, i.e. all components of the test device are physically connected to each other, either directly or indirectly via other components of the test device.

For example, the test device may comprise a simulation unit, which may be called "state machine". The simulation unit is adapted to simulate or simulates the states according to the communicative behaviour of the railway vehicle which is simulated by the test device. In particular, the simulation unit may be adapted to adopt one state of the simulated railway vehicle at a time and to adopt different states of the simulated railway vehicle, one after the other. One of several predefined events may cause the simulation unit to change from one of the possible states to another of the possible states. For example, a communication signal received by the test device from the vehicle under test causes the simulation unit to change to a corresponding state, wherein it preferably depends on the content of the received communication signal if the state of the state machine changes at all and/or into which new state the state of the state machine changes. In addition or alternatively, the state of the state machine may change into another state when the test device has output or is outputting a communication signal to the vehicle under test.

The simulation unit (i.e. the state machine) may be realised by the data processing and control unit.

In particular, the interface unit can be of the same type as interface units used in real railway vehicles in order to communicatively connect railway vehicles of a train. Optionally, the interface unit of the test device may comprise additional capabilities of being directly controlled by the data processing and control unit. In any case, the same type of connector or connectors for connecting the at least one interface unit to the at least one communication channel can be used as in real railway vehicles.

The user interface preferably comprises at least one display for visual output of test results, of details of the test to be performed and/or of other possible tests that can be performed using the test device. In addition or alternatively, the user interface may comprise input means, such as a keyboard and/or a touchscreen and/or a pointing device (for example a computer mouse) enabling a user to interact with and control the test device. In particular, the user may select and start a test using the input means. A data interface of the test device may be provided so that data may be input into and/or or output from the test device.

According to the claims, the test device further comprises a data storage comprising data enabling the data processing and control unit to simulate the communication behaviour according to in each case at least one functionality of different types of railway vehicles that may be coupled to the vehicle under test or to output communication signals to and receive communication signals from another vehicle under test and enabling the data processing and control unit to evaluate the communication signals received in order to determine whether the vehicle under test or the other vehicle under test is correctly functioning within a railway train.

By using the data stored in the data storage, the test device can test different train configurations.

In particular, the at least one interface unit is communicatively connected to the vehicle under test in a manner which is identical to a process of connecting a communication interface of a real railway vehicle to the train communication channel of a real railway train.

Therefore, the test device can be connected to any communication interface of a real vehicle and the vehicle under test can be tested under realistic circumstances.

In particular, the data processing and control unit may be adapted to simulate the communication behaviour according to one functionality or more than one functionality of the at least one first railway vehicle by determining output time(s) of at least one communication signal caused by the one functionality or by the more than one functionality and by outputting the at least one communication signal to the railway vehicle under test at the determined output time(s). The basic thought behind this embodiment is that the communication behaviour alone provides sufficient information to perform a test.

For example, the output time(s) can be stored in a data storage to which the data processing and control unit has access and which may be part of the test device. There may be values of output times stored corresponding to the correct (in case of no malfunction) timing of the simulated functionality or functionalities and corresponding to malfunctions. The data processing and control unit determines at least one output time by accessing the data storage and reading out the stored value. Therefore, it is possible to simulate the functionality or functionalities with correct timing and/or according to a malfunction.

An example of such functionalities is the process of the controlling the closure of an electrical switch and the process of detecting that the electrical switch has been closed. For the simulation of the corresponding communication behavior, namely to output a signal which confirms that the electrical switch has been closed, it is sufficient to output the confirmation signal with a (correct or deliberately incorrect) delay after receipt of a signal that commands closing the switch. This means that simulation of functionalities in this case can be reduced to the performance of a delay from the receipt of the signal received by the test device from the vehicle under test.

However, the invention is not excluded from simulating functionalities of the simulated vehicle in detail.

A different concept of testing railway trains includes testing individual devices of the vehicle under test, for example, the traction control system, the light controls and the door control system. In contrast, there is no need for directly connecting the test device of the present invention to devices of the vehicle under test. The test concept of the present invention relies on the simulation of the overall communication behaviour of the simulated vehicle.

A large number of functions can be tested by only evaluating the communication behaviour of the corresponding devices in the vehicle under test. Furthermore, testing only the communication behaviour facilitates the test and reduces the effort.

In addition or alternatively, information about communication signals to be transferred via the train communication channel can be stored in a data storage in advance and the data processing and control unit can control or can be adapted to control output of communication signals via the at least one interface unit to the railway vehicle under test
∘ in response to communication signals received via the at least one interface unit from the railway vehicle under test and
∘ by considering the information about communication signals which is stored in the data storage.

The basic thought behind this embodiment is that only information about the correct communication behaviour of the simulated rail vehicle and of the vehicle under test must be known in order to perform a test. Using this knowledge, the data processing and control unit can output the correct communication signals either in response to communication signals received from the vehicle under test or in order to start testing a function of the vehicle under test and the data processing and control unit can evaluate the received communication signals using the knowledge whether the communication signals received from the vehicle under test indicate a correct function or not.

Generally, not only related to this specific embodiment, the data processing and control unit can determine whether the communication behaviour of the vehicle under test is correct based on at least one criterion. Preferably, several criteria are used. For example, according to a first criterion, the communication signal(s) received from the vehicle under test must be equal to an expected communication signal or expected communication signals. According to a second criterion, the communication signal(s) received from the vehicle under test must be received within a predetermined time interval starting from a defined action, such as output of a communication signal from the interface unit of the test device to the vehicle under test.

Examples and further embodiments of the invention will be described with reference to the attached figures. The individual figures show:
- Fig. 1: a test device connected via a plurality of communication lines and/or busses to an end carriage of a train as a first example of vehicle under test,
- Fig. 2: the test device and the plurality of communication lines and/or busses of Fig. 1, wherein the test device is connected to a locomotive as a second example of a vehicle under test and wherein the test device is simulating the guiding vehicle of a railway train, i.e. the vehicle comprising the driver controls that are used by the driver to control the operation of the train,
- Fig. 3: an arrangement similar to the arrangement shown in Fig. 2, wherein the locomotive is the guiding vehicle and the test device simulates a guided vehicle, i.e. a vehicle which is remotely controlled by the driver controls within the guiding vehicle,
- Fig. 4: a block diagram schematically illustrating a test device, such as the test device of one of Fig. 1 to 3, a plurality of communication lines and/or busses, a power supply for supplying power to the test device as well as user means for user information and interaction and
- Fig. 5: schematically communication signals transferred between a user (operator or driver), the test device and the vehicle under test

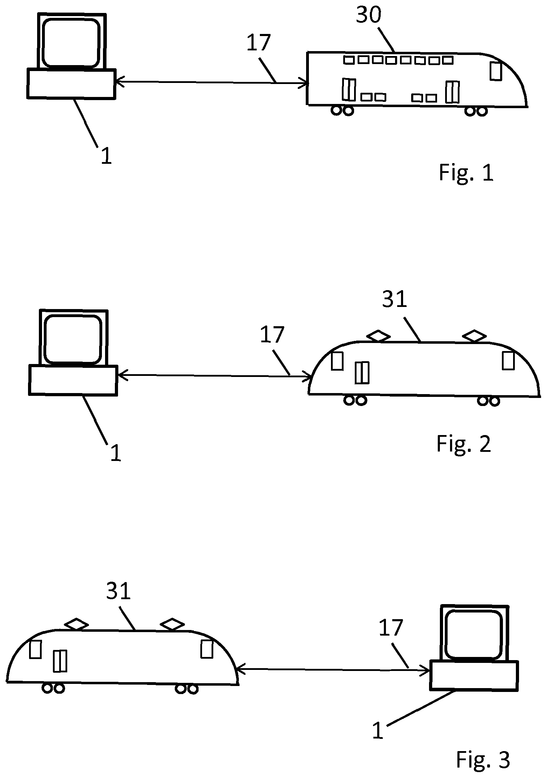

The test device 1 shown in Fig. 1 is connected to a vehicle under test, in this case an end carriage 30, via a plurality of communication lines and/or busses. For example, these communication lines and/or busses can be a WTB and TL (train lines). These communication lines and busses are known in the art. In addition or alternatively, at least one radio channel can be used for communication within the train.

The test device 1 may simulate all vehicles of a railway train except the vehicle under test, which is the end carriage in the case shown in Fig. 1.

Fig. 2 shows a test configuration similar to the test configuration shown in Fig. 1. Instead of an end carriage, a locomotive 31 is the vehicle under test. In particular, the test device 1 simulates the guiding vehicle that includes the driver controls.

Fig. 3 shows a test configuration with a locomotive 31 and a test device 1 like the test configuration shown in Fig. 2, but the test device 1 simulates the guided vehicle that is controlled during operation of the train by the driver controls located within the locomotive 31, the guiding vehicle.

There are many other test configurations which can be formed using one or more than one test devices according to the present invention. For example, two or more test devices simulating different vehicles of a train can be connected to the train communication channel(s). In addition or alternatively, more than one real vehicle can be connected to the connector(s) of the test device(s).

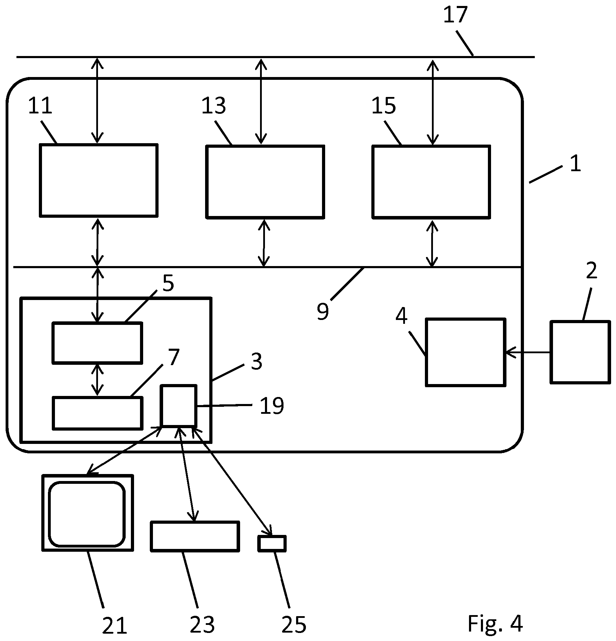

Fig. 4 schematically shows a possible constitution of a test device 1. An external power supply 2 is connected to a converter 4 of the test device 1. The converter 4 may be a DC/DC (direct current/direct current) converter or may be an AC/DC (alternating current/direct current) converter, depending on the circumstances of power supply. The energy supplied by the power supply 2 to the test device 1 is used for operating the test device 1.

The test device 1 comprises a computer 3 which may be a notebook computer in practice. The computer 3 comprises the data processing and control unit 5 which controls the output of signals from the test device 1 via the communication lines and/or busses 17 to the other simulated or real vehicles connected to the communication lines and/or busses 17. Furthermore, the data processing and control unit 5 evaluates the communication signals received from the other simulated or real vehicles via the communication lines and/or busses 17. In addition, the data processing and control unit determines whether the functions performed by the at least one vehicle under test are correct or are malfunctions.

The computer 3 also comprises at least one data storage 7 which may include data files for automatically controlling the test, data files enabling the computer to simulate a real vehicle and/or data files which contain log information from the test and/or test results produced by evaluating the received communication signals.

The computer 3 is connected to, in this case three (in general, any number of), interface units 11, 13, 15 via a data transfer network 9 of the test device 1. The data processing and control unit 5 of the computer 3 controls output of communication signals by controlling the respective interface unit which is used in a railway train for this type of signals. In the specific example shown in Fig. 4, the first interface unit is a WTB interface unit 11, the second interface unit is a TL interface unit 13 and the third interface unit is an Ethernet interface unit 15. However, any other combination of this kind of interface units or other kinds of interface units are adapted to establish and maintain communication within a railway train can be used. For example, interface units for at least one of multiple traction control, push-pull train control and multiplex double-traction control can be used, which are usually abbreviated by "ZxS". An incoming communication signal is received by the respective interface unit 11, 13, 15 and is transferred via the data transfer network 9 to the data processing and control unit 5.

A user interface 19 is part of the computer 3 and, for example, a monitor 21, a keyboard 23 and a computer mouse 25 may be connected to the computer 3 via the user interface 19.

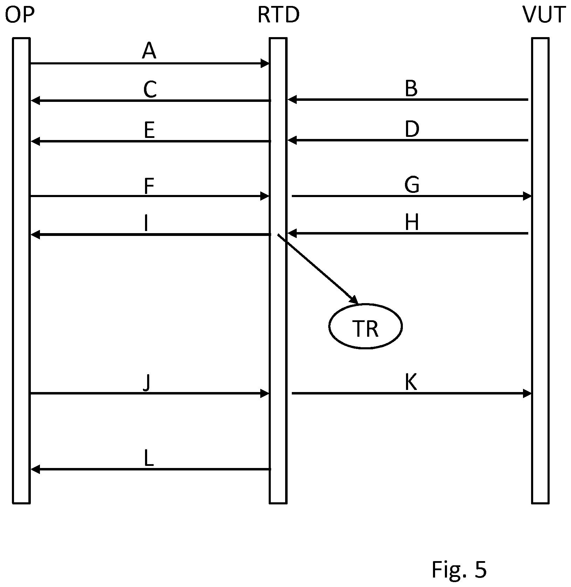

Fig. 5 schematically shows the location where a user OP inputs information that is transferred to the test device RTD and receives information from the test device RTD. The location of the user OP is shown on the left hand side of Fig. 5. The location of the test device RTD is shown in the central region (if viewed from left to right or vice versa) of Fig. 5. In the region on the right hand side of Fig. 5, the location of the vehicle under test (VUT) is schematically shown. In particular, the user OP may input information and receive information at a user interface, which may include a graphical user interface and/or a keyboard and/or a computer mouse.

Horizontal lines with arrows represent transferred information between the user OP and the test device RTD and communication signals transferred between the test device RTD and the vehicle under test VUT. The peaked end of each arrow denotes the location where the information or communication signal is received. Each arrow is further denoted by a single capital letter in order to distinguish the different information and communication signals.

With reference to Fig. 5, an example of a test of the vehicle under test VUT is described in the following. As part of the inauguration of the train, the user OP may first initiate the transfer of certain parameters which are required to perform the test. In the specific example, the test refers to the process of raising the pantograph of the vehicle under test and the user causes the transfer of configuration parameters for pantograph control and optionally also for driver cab activation first, as shown by arrow A in Fig. 5. The specific example described here does not limit the scope of protection and other tests of the vehicle under test VUT may be performed in a similar manner, by transmitting information between the user OP and the test device RTD on one hand and by transmitting communication signals (in particular control signals and/or confirmation signals) between the test device RTD and the vehicle under test VUT on the other hand.

As a further part of the train inauguration, the vehicle under test VUT transfers information about its presence and its status to the test device, such as the information that the vehicle under test VUT is present in the train and information about the conditions which are known in the vehicle under test VUT concerning the operation of the pantograph and/or concerning the pantograph raising process. The corresponding transfer of a communication signal or plural communication signals is indicated in Fig. 5 by arrow B. For example, the conditions relate to the catenary voltage and the country where the train is to be operated. Other than shown in Fig. 5, the transfer of information may be requested by transmitting a corresponding communication signal from the test device RTD to the vehicle under test VUT. In this case, the vehicle under test VUT may just confirm that the conditions actually correspond to the request.

When the conditions have been clarified between the test device RTD and the vehicle under test VUT, the test device RTD may transmit corresponding information to the user OP (for example to the user interface), as indicated by arrow C. Alternatively, different parts of the conditions and/or the train configuration may be transferred and/or confirmed to the user OP one after the other, as soon as the vehicle under test VUT and the test device RTD have negotiated the status and/or the conditions.

The steps mentioned before do not form part of the actual test to be performed which will be described in the following, although these steps described before may secure that the test can be performed successfully.

As a step that directly prepares the test and the corresponding procedure to be performed by the vehicle under test VUT, the vehicle under test VUT transmits the information that the pantograph is lowered (i.e. the pantograph has no electrical contact to the catenary line), as indicated by arrow D. As an optional step, the test device RTD may transmit the information that the pantograph is lowered to the user OP, as indicated by arrow E.

Now the test is started, either automatically by the test device RTD or triggered by the user OP. The illustration of Fig. 5 shows the case that the user OP transmits the command that the pantograph is to be raised to the test device RTD, as indicated by arrow F. In reaction to this command (or alternatively as part of an automatic test procedure not triggered by the user) the test device RTD transmits the command that the pantograph is to be raised in order to make electrical contact with the catenary line to the vehicle under test VUT, as indicated by arrow G.

If the vehicle under test VUT has successfully raised the pantograph, it transmits a corresponding confirmation message to the test device RTD, as indicated by arrow H. The test device RTD evaluates the message by evaluating the corresponding communication signal received from the vehicle under test VUT and decides whether the pantograph has been raised successfully and, therefore, the test has been passed. Optionally, the test device RTD not only determines whether the communication signal according to arrow H contains the information that the pantograph has been raised successfully, but also monitors if the confirmation message has been received within a time interval of predetermined length starting with the output of the command to raise the pantograph, according to arrow G. If the confirmation message is received after the termination of the time interval of predetermined length, the test device RTD may decide that the vehicle under test VUT has failed, i.e. the test has not been performed successfully.

The decision concerning the test result TR is indicated in Fig. 5 by an arrow pointing to an oval with "TR". In the specific example shown, the test device RTD also outputs a message to the user OP indicating that the test has been performed successfully (if applicable) or has not been performed successfully (if applicable) or the pantograph has been raised, but not within the expected time period (if applicable). The corresponding message is represented in Fig. 5 by arrow I. Optionally, the test device RTD may transmit further information about the test and/or the test result to the user OP.

According to a modified method of operating the test device, there can be no information transfer between a user and the test device RTD, or reduced transfer of information between the user OP and the test device RTD. In addition or alternatively, all information which is output to the user OP according to the above description, can be output to a set of logging data, for example stored as a log file.

With reference to the bottom region of Fig. 5 a further procedure which involves the test device is schematically shown and will be described in the following. This procedure can be performed after the test as described before or can be performed separately or in connection with a different test or an additional test.

As indicated by arrow J, the user OP requires that the driver's cab within the vehicle under test VUT is deactivated, since the vehicle under test VUT is not the guiding vehicle in the present train configuration. Instead, the test device RTD simulates the guiding vehicle comprising the driver's cab.

As a result, the test device RTD outputs the message to the vehicle under test VUT that the vehicle under test VUT is not the guiding vehicle, as indicated by arrow K.

With optional message according to arrow L, the test device RTD reports to the user about the test and/or transmits the set of logging data, as indicated by arrow L.

As mentioned above, the test device RTD may evaluate the confirmation message of the vehicle under test VUT when the vehicle under test VUT has received the command (arrow G) that the pantograph is to be raised. The confirmation message (arrow H) may comprise the information that the status of the pantograph is still "lowered", i.e. the pantograph could not make contact to the catenary line. In this case, the test has failed and, in particular, the test device RTD may report about the test failure with the message according to arrow I and/or arrow L.

The user OP may be, for example, a test engineer or a driver who is to be trained driving the railway train. In the latter case, there may be a model of the driver's cab which is equal to or similar to a real driver's cab of the train. Alternatively, the test can be performed automatically, without interaction of a user. In this case, the user interface may be just an interface for output of data, such as the set of log data.

Several other tests can be performed in a similar manner as described with reference to Fig. 5. For example, traction and/or break control can be tested by transmitting communication signals between the test device and the vehicle under test and in particular by evaluating communication signals from the vehicle under test by the test device. Another example of a process which can be tested in a similar manner as shown in Fig. 5 is the opening and closing of passenger doors. Typically, the control signals commanding the opening or closing of the passenger doors are output by the guiding vehicle and corresponding confirmation messages that the respective door is actually closed, are transmitted from other vehicles of the train to the guiding vehicle. For example, the test device may simulate the guiding vehicle and may output the command signal that doors are to be closed. During the test, the test device evaluates whether corresponding confirmation messages that the doors are actually closed are received.

Tests of the communication behaviour related to other functionalities can be performed in a similar manner, for example, the communication behaviour during the opening or closure of several vehicle passenger doors to the outside of the vehicle.

A further example of a test procedure relates to the electrical contact between plural traction systems of the train to an overhead electric line. The electrical contact of different traction systems via in each case one main switch to the electric overhead line should not be made at the same time, since this may cause interfering frequencies with amplitudes that are not permissible or at least not necessary. Therefore, monitoring and evaluating the times of making contact with the electric line should be part of a corresponding test.

For example, the test device simulates the behaviour of the vehicle, the traction system of which should make contact with the electric line as the second traction system of the train. When the test device receives the command to close its main switch, it is sufficient to simulate the process of switching and detecting electrical contact with the overhead line by outputting the confirmation signal with the information "electrical contact to the overhead line has been made" with a first delay after the receipt of the command signal. The length of the first delay corresponds to the process when no malfunction occurs and the value of the length is, for example, stored in a data storage of the test device. The test device outputs the confirmation signal according to the delay, or during a different test, deliberately with another delay or without a delay in order to simulate a malfunction.

In the following, an example of a test device is described which has a plurality of operation modes. In a first mode, which can be called "user mode", a state machine of the test device is operated and a user can influence the operation of the state machine via the user interface. For example the user may choose a specific state to be simulated by the state machine.

In a second mode, which can be called "sequence mode", the operation of the state machine is automatically controlled, e.g. by commands written in a data file that is stored in a data storage which is part of the test device or which is connected to the test device. The data file may be an XML (extended markup language) file, for example. Optionally, the state machine can also be influenced by a user via the user interface.

In a third mode, which can be called "communication mode", the state machine is not operated. A user can directly control output of signals or of information carried by signals, which signals are output by the interface unit to the vehicle under test.

Optionally, there is a fourth mode, which can be called "recording mode". In this mode, the user action is recorded in a data file, such as an XML file. The recording mode can be chosen to be performed at the same time as the user mode or the communication mode.

### List of reference signs

- 1: test device
- 2: power supply
- 3: computer
- 4: converter
- 5: data processing and control unit
- 7: data storage
- 9: data transfer network
- 11: WTB interface unit
- 13: TL interface unit
- 15: Ethernet interface unit
- 17: communication lines and/or busses (communication channels)
- 19: user interface
- 21: monitor
- 23: keyboard
- 25: computer mouse
- 30: end carriage
- 31: locomotive
- OP: user
- RTD: test device
- VUT: vehicle under test

## Claims

1. A test device (1) for testing interoperability of railway vehicles (30, 31) that are intended to be part of a railway train, wherein the test device (1) comprises:
- at least one interface unit (11, 13, 15) adapted to establish and maintain communication between the test device (1) and a railway vehicle (30, 31) under test via a train communication channel (17),
- at least one connector for connecting the train communication channel (17) to the at least one interface unit (11, 13, 15),
- a data processing and control unit (5) adapted to
∘ control output of communication signals via the at least one interface unit (11, 13, 15) to the railway vehicle (30, 31) under test and
∘ process communication signals received via the at least one interface unit (11, 13, 15) from the railway vehicle (30, 31) under test,
thereby simulating a communication behaviour according to at least one functionality of a first railway vehicle coupled via the train communication channel (17) to the railway vehicle (30, 31) under test,
- a user interface adapted to output test results from testing the railway vehicle (30, 31) under test to a user and/or adapted to receive control input from a user in order to initiate and/or control testing the railway vehicle (30, 31) under test,
**characterized in that**
the test device (1) further comprises a data storage (7) comprising data enabling the data processing and control unit (5) to simulate the communication behaviour of different types of railway vehicles that may be coupled to the railway vehicle (30, 31) under test or to another railway vehicle under test and enabling the data processing and control unit (5) to evaluate the communication signals received in order to determine whether the railway vehicle (30, 31) under test or the other railway vehicle under test is correctly functioning within a railway train.

2. The test device of claim 1, wherein the data processing and control unit (5) is also adapted to evaluate the communication signals received via the at least one interface unit (11, 13, 15), thereby determining whether the railway vehicle (30, 31) under test is correctly functioning within a railway train.

3. The test device of claim 1 or 2, wherein the data processing and control unit (5) is adapted to simulate the communication behaviour according to one functionality or more than one functionality of the first railway vehicle by determining output time(s) of at least one communication signal caused by the one functionality or by the more than one functionality and by outputting the at least one communication signal to the railway vehicle (30, 31) under test at the determined output time(s).

4. The test device of one of claims 1 to 3, wherein the at least one interface unit (11, 13, 15) is adapted to be communicatively connected to the railway vehicle (30, 31) under test in a manner which is identical to a process of connecting a communication interface of a real railway vehicle to the train communication channel (17) of a real railway train.

5. The test device of one of claims 1 to 4, wherein the data processing and control unit (5) is adapted to simulate just the communication behaviour of the first railway vehicle without simulating further functions of devices of the first railway vehicle.

6. The test device of claim 5, wherein information about communication signals to be transferred via the train communication channel (17) is stored in a data storage in advance and wherein the data processing and control unit (5) is adapted to control output of communication signals via the at least one interface unit (11, 13, 15) to the railway vehicle (30, 31) under test
∘ in response to communication signals received via the at least one interface unit (11, 13, 15) from the railway vehicle (30, 31) under test and
∘ by considering the information about communication signals which is stored in the data storage (7).

7. The test device of one of claims 1 to 6, wherein the test device (1) is adapted to test a communication behaviour of the railway vehicle (30, 31) under test while the test device (1) is communicatively coupled to the railway vehicle (30, 31) under test, but is not mechanically coupled to the railway vehicle (30, 31) under test like different railway vehicles of a railway train are mechanically coupled together.

8. A method of testing interoperability of railway vehicles (30, 31) that are intended to be part of a railway train, wherein a test device (1) is communicatively coupled to a railway vehicle (30, 31) under test, and wherein:
- at least one interface unit (11, 13, 15) of the test device (1) is used to establish and maintain communication between the test device (1) and a railway vehicle (30, 31) under test via a train communication channel (17),
- at least one connector of the test device (1) is used for connecting the train communication channel (17) to the at least one interface unit (11, 13, 15),
- a data processing and control unit (5) of the test device (1)
∘ controls output of communication signals via the at least one interface unit (11, 13, 15) to the railway vehicle (30, 31) under test and
∘ processes communication signals received via the at least one interface unit (11, 13, 15) from the railway vehicle (30, 31) under test,
thereby simulating a communication behaviour of a first railway vehicle (30, 31) coupled via the train communication channel (17) to the railway vehicle (30, 31) under test,
- a user interface outputs test results from testing the railway vehicle (30, 31) under test to a user and/or is used to receive control input from a user in order to initiate and/or control testing the railway vehicle (30, 31) under test,
**characterized in that**
a data storage (7) is used in connection with the test device (1), wherein the data storage (7) comprises data enabling the data processing and control unit (5) to simulate the communication behaviour of different types of railway vehicles that may be coupled to the railway vehicle under test or to another railway vehicle (30, 31) under test and enabling the data processing and control unit (5) to evaluate the communication signals received in order to determine whether the railway vehicle (30, 31) under test or the other railway vehicle under test is correctly functioning within a railway train..

9. The method of claim 8, wherein the data processing and control unit (5) also evaluates the communication signals received via the at least one interface unit (11, 13, 15), thereby determining whether the railway vehicle (30, 31) under test is correctly functioning within a railway train.

10. The method of claim 8 or 9, wherein the data processing and control unit (5) simulates the communication behaviour according to one functionality or more than one functionality of the first railway vehicle by determining output time(s) of at least one communication signal caused by the one functionality or by the more than one functionality and by outputting the at least one communication signal to the railway vehicle under test at the determined output time(s).

11. The method of one of claims 8 to 10, wherein the at least one interface unit (11, 13, 15) is communicatively connected to the railway vehicle (30, 31) under test in a manner which is identical to a process of connecting a communication interface of a real railway vehicle to the train communication channel (17) of a real railway train.

12. The method of one of claims 8 to 11, wherein the data processing and control unit (5) simulates just the communication behaviour of the first railway vehicle without simulating further functions of devices of the first railway vehicle and wherein the data processing and control unit (5) controls output of communication signals via the at least one interface unit (11, 13, 15) to the railway vehicle (30, 31) under test
∘ in response to communication signals received via the at least one interface unit (11, 13, 15) from the railway vehicle (30, 31) under test and
∘ by considering the information about communication signals which is stored in the data storage (7),
wherein information about communication signals to be transferred via the train communication channel (17), which information has been stored in a data storage (7) in advance, is used by the data processing and control unit (5) when controlling the output of communication signals.

13. The method of one of claims 8 to 12, wherein the test device (1) performs a test comprising a communication behaviour of the railway vehicle (30, 31) under test while the test device (1) is communicatively coupled to the railway vehicle (30, 31) under test, but is not mechanically coupled to the railway vehicle (30, 31) under test like different railway vehicles of a railway train are mechanically coupled together.

## Patentansprüche

1. Testvorrichtung (1) zum Testen von Interoperabilität von Schienenfahrzeugen (30, 31), die dazu vorgesehen sind, Teil eines Eisenbahnzuges zu sein, wobei die Testvorrichtung (1) umfasst:
- mindestens eine Schnittstelleneinheit (11, 13, 15), dazu angepasst, Kommunikation zwischen der Testvorrichtung (1) und einem zu testenden Schienenfahrzeug (30, 31) über einen Zugkommunikationskanal (17) aufzubauen und aufrechtzuerhalten,
- mindestens einen Verbinder zum Verbinden des Zugkommunikationskanals (17) mit der mindestens einen Schnittstelleneinheit (11, 13, 15),
- eine Datenverarbeitungs- und Steuerungseinheit (5), dazu angepasst
∘ die Ausgabe von Kommunikationssignalen über die mindestens eine Schnittstelleneinheit (11, 13, 15) an das zu testende Schienenfahrzeug (30, 31) zu steuern, und
∘ Kommunikationssignale zu verarbeiten, die über die mindestens eine Schnittstelleneinheit (11, 13, 15) von dem zu testenden Schienenfahrzeug (30, 31) empfangen werden,
und dadurch ein Kommunikationsverhalten gemäß mindestens einer Funktionalität eines ersten Schienenfahrzeugs, das über den Zugkommunikationskanal (17) mit dem zu testenden Schienenfahrzeug (30, 31) verbunden ist, zu simulieren,
- eine Benutzerschnittstelle, dazu angepasst, Testergebnisse vom Testen des zu testenden Schienenfahrzeugs (30, 31) an einen Benutzer auszugeben, und/oder dazu angepasst, eine Steuerungseingabe von einem Benutzer zu empfangen, um ein Testen des zu testenden Schienenfahrzeugs (30, 31) einzuleiten und/oder zu steuern,
**dadurch gekennzeichnet, dass**
die Testvorrichtung (1) ferner einen Datenspeicher (7) umfasst, der Daten umfasst, welche der Datenverarbeitungs- und Steuerungseinheit (5) ermöglichen, das Kommunikationsverhalten unterschiedlicher Typen von Schienenfahrzeugen, die mit dem zu testenden Schienenfahrzeug (30, 31) oder mit einem anderen zu testenden Schienenfahrzeug verbunden sein können, zu simulieren, und der Datenverarbeitungs- und Steuerungseinheit (5) ermöglichen, die empfangenen Kommunikationssignale zu evaluieren, um festzustellen, ob das zu testende Schienenfahrzeug (30, 31) oder das andere zu testende Schienenfahrzeug ordnungsgemäß innerhalb eines Eisenbahnzuges funktioniert.

2. Testvorrichtung nach Anspruch 1, wobei die Datenverarbeitungs- und Steuerungseinheit (5) auch dazu angepasst ist, die über die mindestens eine Schnittstelleneinheit (11, 13, 15) empfangenen Kommunikationssignale zu evaluieren und dabei festzustellen, ob das zu testende Schienenfahrzeug (30, 31) ordnungsgemäß innerhalb eines Eisenbahnzuges funktioniert.

3. Testvorrichtung nach Anspruch 1 oder 2, wobei die Datenverarbeitungs- und Steuerungseinheit (5) dazu angepasst ist, das Kommunikationsverhalten gemäß einer Funktionalität oder mehr als einer Funktionalität des ersten Schienenfahrzeugs durch Feststellen einer Ausgabezeit / von Ausgabezeiten mindestens eines Kommunikationssignals, das durch die eine Funktionalität oder durch die mehr als eine Funktionalität ausgelöst wurde, und durch Ausgeben des mindestens einen Kommunikationssignals an das zu testende Schienenfahrzeug (30, 31) zu der / den festgestellten Ausgabezeit(en) zu simulieren.

4. Testvorrichtung nach einem der Ansprüche 1 bis 3, wobei die mindestens eine Schnittstelleneinheit (11, 13, 15) dazu angepasst ist, in einer Weise kommunikativ mit dem zu testenden Schienenfahrzeug (30, 31) verbunden zu sein, die mit einem Prozess des Verbindens einer Kommunikationsschnittstelle eines realen Schienenfahrzeugs mit dem Zugkommunikationskanal (17) eines realen Eisenbahnzuges identisch ist.

5. Testvorrichtung nach einem der Ansprüche 1 bis 4, wobei die Datenverarbeitungs- und Steuerungseinheit (5) dazu angepasst ist, nur das Kommunikationsverhalten des ersten Schienenfahrzeugs zu simulieren, ohne weitere Funktionen von Vorrichtungen des ersten Schienenfahrzeugs zu simulieren.

6. Testvorrichtung nach Anspruch 5, wobei Informationen über Kommunikationssignale, die über den Zugkommunikationskanal (17) zu übertragen sind, vorab in einem Datenspeicher gespeichert werden, und wobei die Datenverarbeitungs- und Steuerungseinheit (5) dazu angepasst ist, die Ausgabe von Kommunikationssignalen über die mindestens eine Schnittstelleneinheit (11, 13, 15) an das zu testende Schienenfahrzeug (30, 31) zu steuern
∘ in Reaktion auf Kommunikationssignale, die über die mindestens eine Schnittstelleneinheit (11, 13, 15) von dem zu testenden Schienenfahrzeug (30, 31) empfangen werden, und
∘ durch Berücksichtigung der Informationen über Kommunikationssignale, die im Datenspeicher (7) gespeichert sind.

7. Testvorrichtung nach einem der Ansprüche 1 bis 6, wobei die Testvorrichtung (1) dazu angepasst ist, ein Kommunikationsverhalten des zu testenden Schienenfahrzeugs (30, 31) zu testen, während die Testvorrichtung (1) kommunikativ mit dem zu testenden Schienenfahrzeug (30, 31) verbunden ist, jedoch nicht mechanisch mit dem zu testenden Schienenfahrzeug (30, 31) verbunden ist, wie andere Schienenfahrzeuge eines Eisenbahnzuges mechanisch miteinander verbunden sind.

8. Verfahren zum Testen der Interoperabilität von Schienenfahrzeugen (30, 31), die vorgesehen sind, Teil eines Eisenbahnzuges zu sein, wobei eine Testvorrichtung (1) kommunikativ mit einem zu testenden Schienenfahrzeug (30, 31) verbunden ist, und wobei:
- mindestens eine Schnittstelleneinheit (11, 13, 15) der Testvorrichtung (1) dazu verwendet wird, eine Kommunikation zwischen der Testvorrichtung (1) und einem zu testenden Schienenfahrzeug (30, 31) über einen Zugkommunikationskanal (17) aufzubauen und aufrechtzuerhalten,
- mindestens ein Verbinder der Testvorrichtung (1) zum Verbinden des Zugkommunikationskanals (17) mit der mindestens einen Schnittstelleneinheit (11, 13, 15) verwendet wird,
- eine Datenverarbeitungs- und Steuerungseinheit (5) der Testvorrichtung (1)
∘ die Ausgabe von Kommunikationssignalen über die mindestens eine Schnittstelleneinheit (11, 13, 15) an das zu testende Schienenfahrzeug (30, 31) steuert, und
∘ Kommunikationssignale verarbeitet, die über die mindestens eine Schnittstelleneinheit (11, 13, 15) von dem zu testenden Schienenfahrzeug (30, 31) empfangen werden,
wodurch ein Kommunikationsverhalten eines ersten Schienenfahrzeugs (30, 31), das über den Zugkommunikationskanal (17) mit dem zu testenden Schienenfahrzeug (30, 31) verbunden ist, simuliert wird,
- eine Benutzerschnittstelle Testergebnisse vom Testen des zu testenden Schienenfahrzeugs (30, 31) an einen Benutzer ausgibt und/oder verwendet wird, um eine Steuerungseingabe von einem Benutzer zu empfangen, um ein Testen des zu testenden Schienenfahrzeugs (30, 31) einzuleiten und/oder zu steuern,
**dadurch gekennzeichnet, dass**
ein Datenspeicher (7) in Verbindung mit der Testvorrichtung (1) verwendet wird, wobei der Datenspeicher (7) Daten umfasst, welche der Datenverarbeitungs- und Steuerungseinheit (5) ermöglichen, das Kommunikationsverhalten unterschiedlicher Typen von Schienenfahrzeugen, die mit dem zu testenden Schienenfahrzeug oder mit einem anderen zu testenden Schienenfahrzeug (30, 31) verbunden sein können, zu simulieren, und der Datenverarbeitungs- und Steuerungseinheit (5) ermöglichen, die empfangenen Kommunikationssignale zu evaluieren, um festzustellen, ob das zu testende Schienenfahrzeug (30, 31) oder das andere zu testende Schienenfahrzeug ordnungsgemäß innerhalb eines Eisenbahnzuges funktioniert.

9. Verfahren nach Anspruch 8, wobei die Datenverarbeitungs- und Steuerungseinheit (5) auch die über die mindestens eine Schnittstelleneinheit (11, 13, 15) empfangenen Kommunikationssignale evaluiert und dabei feststellt, ob das zu testende Schienenfahrzeug (30, 31) ordnungsgemäß innerhalb eines Eisenbahnzuges funktioniert.

10. Verfahren nach Anspruch 8 oder 9, wobei die Datenverarbeitungs- und Steuerungseinheit (5) das Kommunikationsverhalten gemäß einer Funktionalität oder mehr als einer Funktionalität des ersten Schienenfahrzeugs durch Feststellen einer Ausgabezeit / von Ausgabezeiten mindestens eines Kommunikationssignals, das durch die eine Funktionalität oder durch die mehr als eine Funktionalität ausgelöst wurde, und durch Ausgeben des mindestens einen Kommunikationssignals an das zu testende Schienenfahrzeug zu der / den festgestellten Ausgabezeit(en) simuliert.

11. Verfahren nach einem der Ansprüche 8 bis 10, wobei die mindestens eine Schnittstelleneinheit (11, 13, 15) kommunikativ mit dem zu testenden Schienenfahrzeug (30, 31) in einer Weise verbunden ist, die mit einem Prozess des Verbindens einer Kommunikationsschnittstelle eines realen Schienenfahrzeugs mit dem Zugkommunikationskanal (17) des realen Eisenbahnzuges identisch ist.

12. Verfahren nach einem der Ansprüche 8 bis 11, wobei die Datenverarbeitungs- und Steuerungseinheit (5) nur das Kommunikationsverhalten des ersten Schienenfahrzeugs simuliert, ohne weitere Funktionen von Vorrichtungen des ersten Schienenfahrzeugs zu simulieren, und wobei die Datenverarbeitungs- und Steuerungseinheit (5) die Ausgabe von Kommunikationssignalen über die mindestens eine Schnittstelleneinheit (11, 13, 15) an das zu testende Schienenfahrzeug (30, 31) steuert
∘ in Reaktion auf Kommunikationssignale, die über die mindestens eine Schnittstelleneinheit (11, 13, 15) von dem zu testenden Schienenfahrzeug (30, 31) empfangen werden, und
∘ durch Berücksichtigung der Informationen über Kommunikationssignale, die im Datenspeicher (7) gespeichert sind,
wobei Informationen über Kommunikationssignale, die über den Zugkommunikationskanal (17) zu übertragen sind, wobei diese Informationen vorab im Datenspeicher (7) gespeichert wurden, von der Datenverarbeitungs- und Steuerungseinheit (5) beim Steuern der Ausgabe von Kommunikationssignalen verwendet werden.

13. Verfahren nach einem der Ansprüche 8 bis 12, wobei die Testvorrichtung (1) einen Test ausführt, der ein Kommunikationsverhalten des zu testenden Schienenfahrzeugs (30, 31) umfasst, während die Testvorrichtung (1) kommunikativ mit dem zu testenden Schienenfahrzeug (30, 31) verbunden ist, jedoch nicht mechanisch mit dem zu testenden Schienenfahrzeug (30, 31) verbunden ist, wie andere Schienenfahrzeuge eines Eisenbahnzuges mechanisch miteinander verbunden sind.

## Revendications

1. Dispositif de test (1) pour tester une interopérabilité de véhicules ferroviaires (30, 31) qui sont destinés à faire partie d'un train ferroviaire, dans lequel le dispositif de test (1) comprend :
- au moins une unité d'interface (11, 13, 15) adaptée pour établir et maintenir une communication entre le dispositif de test (1) et un véhicule ferroviaire (30, 31) soumis à un test via un canal de communication de train (17),
- au moins un connecteur pour connecter le canal de communication de train (17) à l'au moins une unité d'interface (11, 13, 15),
- une unité de traitement de données et de commande (5) adaptée pour
∘ commander l'émission de signaux de communication via l'au moins une unité d'interface (11, 13, 15) au véhicule ferroviaire (30, 31) soumis à un test et
∘ traiter des signaux de communication reçus via l'au moins une unité d'interface (11, 13, 15) depuis le véhicule ferroviaire (30, 31) soumis à un test,
en simulant ainsi un comportement de communication en fonction d'au moins une fonctionnalité d'un premier véhicule ferroviaire couplé via le canal de communication de train (17) au véhicule ferroviaire (30, 31) soumis à un test,
- une interface d'utilisateur adaptée pour délivrer des résultats de test du test du véhicule ferroviaire (30, 31) soumis à un test à un utilisateur et/ou adaptée pour recevoir une entrée de commande depuis un utilisateur afin de lancer et/ou de commander le test du véhicule ferroviaire (30, 31) soumis à un test,
**caractérisé en ce que**
le dispositif de test (1) comprend en outre un stockage de données (7) comprenant des données permettant à l'unité de traitement de données et de commande (5) de simuler le comportement de communication de différents types de véhicules ferroviaires qui peuvent être couplés au véhicule ferroviaire (30, 31) soumis à un test ou à un autre véhicule ferroviaire soumis à un test et permettant à l'unité de traitement de données et de commande (5) d'évaluer les signaux de communication reçus afin de déterminer si le véhicule ferroviaire (30, 31) soumis à un test ou l'autre véhicule ferroviaire soumis à un test fonctionne correctement à l'intérieur d'un train ferroviaire.

2. Dispositif de test selon la revendication 1, dans lequel l'unité de traitement de données et de commande (5) est également adaptée pour évaluer les signaux de communication reçus via l'au moins une unité d'interface (11, 13, 15), en déterminant ainsi si le véhicule ferroviaire (30, 31) soumis à un test fonctionne correctement à l'intérieur d'un train ferroviaire.

3. Dispositif de test selon la revendication 1 ou 2, dans lequel l'unité de traitement de données et de commande (5) est adaptée pour simuler le comportement de communication en fonction d'une fonctionnalité ou de plusieurs fonctionnalités du premier véhicule ferroviaire par la détermination d'un ou de temps d'émission d'au moins un signal de communication provoqué par la fonctionnalité ou par les fonctionnalités et par l'émission de l'au moins un signal de communication au véhicule ferroviaire (30, 31) soumis à un test au(x) temps d'émission déterminé(s).

4. Dispositif de test selon l'une des revendications 1 à 3, dans lequel l'au moins une unité d'interface (11, 13, 15) est adaptée pour être connectée en communication au véhicule ferroviaire (30, 31) soumis à un test d'une manière qui est identique à un processus de connexion d'une interface de communication d'un véhicule ferroviaire réel au canal de communication de train (17) d'un train ferroviaire réel.

5. Dispositif de test selon l'une des revendications 1 à 4, dans lequel l'unité de traitement de données et de commande (5) est adaptée pour simuler juste le comportement de communication du premier véhicule ferroviaire sans simuler d'autres fonctions de dispositifs du premier véhicule ferroviaire.

6. Dispositif de test selon la revendication 5, dans lequel des informations relatives à des signaux de communication à transférer via le canal de communication de train (17) sont stockées à l'avance dans un stockage de données et dans lequel l'unité de traitement de données et de commande (5) est adaptée pour commander l'émission de signaux de communication via l'au moins une unité d'interface (11, 13, 15) au véhicule ferroviaire (30, 31) soumis à un test
∘ en réponse à des signaux de communication reçus via l'au moins une unité d'interface (11, 13, 15) depuis le véhicule ferroviaire (30, 31) soumis à un test et
∘ en tenant compte des informations relatives à des signaux de communication qui sont stockées dans le stockage de données (7).

7. Dispositif de test selon l'une des revendications 1 à 6, dans lequel le dispositif de test (1) est adapté pour tester un comportement de communication du véhicule ferroviaire (30, 31) soumis à un test pendant que le dispositif de test (1) est couplé en communication au véhicule ferroviaire (30, 31) soumis à un test, mais n'est pas mécaniquement couplé au véhicule ferroviaire (30, 31) soumis à un test comme différents véhicules ferroviaires d'un train ferroviaire sont mécaniquement couplés les uns aux autres.

8. Procédé de test d'interopérabilité de véhicules ferroviaires (30, 31) qui sont destinés à faire partie d'un train ferroviaire, dans lequel un dispositif de test (1) est couplé en communication à un véhicule ferroviaire (30, 31) soumis à un test, et dans lequel :
- au moins une unité d'interface (11, 13, 15) du dispositif de test (1) est utilisée pour établir et maintenir une communication entre le dispositif de test (1) et un véhicule ferroviaire (30, 31) soumis à un test via un canal de communication de train (17),
- au moins un connecteur du dispositif de test (1) est utilisé pour connecter le canal de communication de train (17) à l'au moins une unité d'interface (11, 13, 15),
- une unité de traitement de données et de commande (5) du dispositif de test (1)
∘ commande une émission de signaux de communication via l'au moins une unité d'interface (11, 13, 15) au véhicule ferroviaire (30, 31) soumis à un test et
∘ traite des signaux de communication reçus via l'au moins une unité d'interface (11, 13, 15) depuis le véhicule ferroviaire (30, 31) soumis à un test,
en simulant ainsi un comportement de communication d'un premier véhicule ferroviaire (30, 31) couplé via le canal de communication de train (17) au véhicule ferroviaire (30, 31) soumis à un test,
- une interface d'utilisateur délivre des résultats de test du test du véhicule ferroviaire (30, 31) soumis à un test à un utilisateur et/ou est utilisée pour recevoir une entrée de commande depuis un utilisateur afin de lancer et/ou de commander le test du véhicule ferroviaire (30, 31) soumis à un test,
**caractérisé en ce que**
un stockage de données (7) est utilisé en relation avec le dispositif de test (1), dans lequel le stockage de données (7) comprend des données permettant à l'unité de traitement de données et de commande (5) de simuler le comportement de communication de différents types de véhicules ferroviaires qui peuvent être couplés au véhicule ferroviaire soumis à un test ou à un autre véhicule ferroviaire (30, 31) soumis à un test et permettant à l'unité de traitement de données et de commande (5) d'évaluer les signaux de communication reçus afin de déterminer si le véhicule ferroviaire (30, 31) soumis à un test ou l'autre véhicule ferroviaire soumis à un test fonctionne correctement à l'intérieur d'un train ferroviaire.

9. Procédé selon la revendication 8, dans lequel l'unité de traitement de données et de commande (5) évalue également les signaux de communication reçus via l'au moins une unité d'interface (11, 13, 15), en déterminant ainsi si le véhicule ferroviaire (30, 31) soumis à un test fonctionne correctement à l'intérieur d'un train ferroviaire.

10. Procédé selon la revendication 8 ou 9, dans lequel l'unité de traitement de données et de commande (5) simule le comportement de communication en fonction d'une fonctionnalité ou de plusieurs fonctionnalités du premier véhicule ferroviaire par la détermination d'un ou de temps d'émission d'au moins un signal de communication provoqué par la fonctionnalité ou par les fonctionnalités et par l'émission de l'au moins un signal de communication au véhicule ferroviaire soumis à un test au(x) temps d'émission déterminé(s).

11. Procédé selon l'une des revendications 8 à 10, dans lequel l'au moins une unité d'interface (11, 13, 15) est connectée en communication au véhicule ferroviaire (30, 31) soumis à un test d'une manière qui est identique à un processus de connexion d'une interface de communication d'un véhicule ferroviaire réel au canal de communication de train (17) d'un train ferroviaire réel.

12. Procédé selon l'une des revendications 8 à 11, dans lequel l'unité de traitement de données et de commande (5) simule juste le comportement de communication du premier véhicule ferroviaire sans simuler d'autres fonctions de dispositifs du premier véhicule ferroviaire et dans lequel l'unité de traitement de données et de commande (5) commande une émission de signaux de communication via l'au moins une unité d'interface (11, 13, 15) au véhicule ferroviaire (30, 31) soumis à un test
∘ en réponse à des signaux de communication reçus via l'au moins une unité d'interface (11, 13, 15) depuis le véhicule ferroviaire (30, 31) soumis à un test et
∘ en tenant compte des informations relatives à des signaux de communication qui sont stockées dans le stockage de données (7),
dans lequel des informations relatives à des signaux de communication à transférer via le canal de communication de train (17), lesquelles informations sont stockées à l'avance dans un stockage de données (7), sont utilisées par l'unité de traitement de données et de commande (5) lors de la commande d'émission de signaux de communication.

13. Procédé selon l'une des revendications 8 à 12, dans lequel le dispositif de test (1) réalise un test comprenant un comportement de communication du véhicule ferroviaire (30, 31) soumis à un test pendant que le dispositif de test (1) est couplé en communication au véhicule ferroviaire (30, 31) soumis à un test, mais n'est pas mécaniquement couplé au véhicule ferroviaire (30, 31) soumis à un test comme différents véhicules ferroviaires d'un train ferroviaire sont mécaniquement couplés les uns aux autres.
